# EUROPEAN PATENT APPLICATION

(11) **EP 1 536 491 A2**
(43) Date of publication of application: **01.06.2005**
(21) Application number: 04027856.6
(22) Date of filing: 24.11.2004
(51) Int. Cl.: H01L 51/20

(54) **Organic electroluminescent element, method of manufacturing the same and lighting unit**

(30) Priority: 25.11.2003 JP 2003393199
(71) Applicant: Kabushiki Kaisha Toyota Jidoshokki, Kariya-shi, Aichi-ken (JP)
(72) Inventor: Kato, Yoshifumi, K.K. Toyota Jidoshokki, Kariya-shi Aichi-ken (JP); Ito, Hironori, K.K. Toyota Jidoshokki, Kariya-shi Aichi-ken (JP); Utsumi, Tetsuya, K.K. Toyota Jidoshokki, Kariya-shi Aichi-ken (JP)
(74) Representative: Leson, Thomas Johannes Alois, Dipl.-Ing.

(57) **Abstract**

An organic electroluminescent element has a substrate, a first electrode, an organic layer, a second electrode, a sealing member, a first terminal, and a through hole. The first electrode is layered on the substrate. The organic layer that includes a light-emitting layer is layered on the first electrode. The second electrode is layered on the organic layer. The sealing member partially covers the second electrode. A portion of the second electrode, which is not covered with the sealing member, functions as a second terminal. The first terminal is provided on the sealing member on a side opposite to the second electrode. The through hole extends through the sealing member, the second electrode, and the organic layer and is used for connecting the first electrode and the first terminal. The first electrode and the second electrode are electrically connected to a power source.

## Description

### BACKGROUND OF THE INVENTION

The present invention relates to an organic electroluminescent element, a method of manufacturing the same and a lighting unit including the organic electroluminescent element.

An organic electroluminescent element or an organic EL element is a planar selfluminous element and emits light when a voltage is externally applied. A terminal for externally applying the voltage to the organic EL element is usually provided in another region, which is positioned around a luminescent portion for emitting light. The region where the terminal is provided generally does not emit light. Therefore, the organic EL element has a portion that does not emit light (non-light-emitting portion).

In order to reduce the non-tight-emitting portion of the organic EL element, there has been a structure disclosed in FIG. 1 of Unexamined Japanese Patent Publication No. 2000-68051. However, this structure includes a through hole electrode on its substrate, it may be inconvenient when light is output particularly from the side of the substrate. Therefore, there is a need for providing an organic EL element that reduces a non-tight-emitting portion positioned around a tight-emitting portion on its substrate.

### SUMMARY OF THE INVENTION

In accordance with the present invention, an organic electroluminescent element has a substrate, a first electrode, an organic layer, a second electrode, a sealing member, a first terminal and a through hole. The first electrode is layered on the substrate. The organic layer that includes a light-emitting layer is layered on the first electrode. The second electrode is layered on the organic layer. The sealing member partially covers the second electrode. A portion of the second electrode, which is not covered with the sealing member, functions as a second terminal. The first terminal is provided on a side of the sealing member that is opposite to the second electrode. The through hole extends through the sealing member, the second electrode, and the organic layer for connecting the first electrode and the first terminal. The first electrode and the second electrode are electrically connected to a power source.

The present invention also provides a method of manufacturing an organic electroluminescent element. The method includes depositing on a substrate a first electrode, an organic layer that includes a light-emitting layer, and a second electrode, in this order. Next, a hole is drilled that extends through the second electrode and the organic layer. Then, a mask is applied to a portion of the second electrode. Next, a sealant is applied to a portion of the second electrode that is not covered with the mask, end surfaces of the first electrode and the organic layer, and an inner surface of the through hole. Finally, a first terminal is formed that contacts the sealing member and is electrically connected to the first electrode through the through hole.

Other aspects and advantages of the invention will become apparent from the following description, taken in conjunction with the accompanying drawings, illustrating by way of example the principles of the invention.

### BRIEF DESCRIPTION OF THE DRAWINGS

The features of the present invention that are believed to be novel are set forth with particularity in the appended claims. The invention together with objects and advantages thereof, may best be understood by reference to the following description of the presently preferred embodiments together with the accompanying drawings in which:
FIG. 1A is a schematic cross-sectional view of an organic electroluminescent element according to a first preferred embodiment of the present invention;
FIG. 1B is a schematic front-end view of the organic electroluminescent element according to the first preferred embodiment of the present invention;
FIG. 2A is a schematic view showing a film deposition process of the organic electroluminescent element according to the first preferred embodiment of the present invention;
FIG. 2B is a schematic view showing a drilling process of the organic electroluminescent element according to the first preferred embodiment of the present invention;
FIG. 2C is a schematic view showing a sealing process of the organic electroluminescent element according to the first preferred embodiment of the present invention;
FIG. 2D is a schematic view showing a terminal forming process of the organic electroluminescent element according to the first preferred embodiment of the present invention;
FIG. 3A is a schematic back-side view of a lighting unit according to a second preferred embodiment of the present invention; and
FIG. 3B is a schematic cross-sectional view of the lighting unit according to the second preferred embodiment of the present invention.

### DETAILED DESCRIPTION OF THE PREFERRED EMBODIMENTS

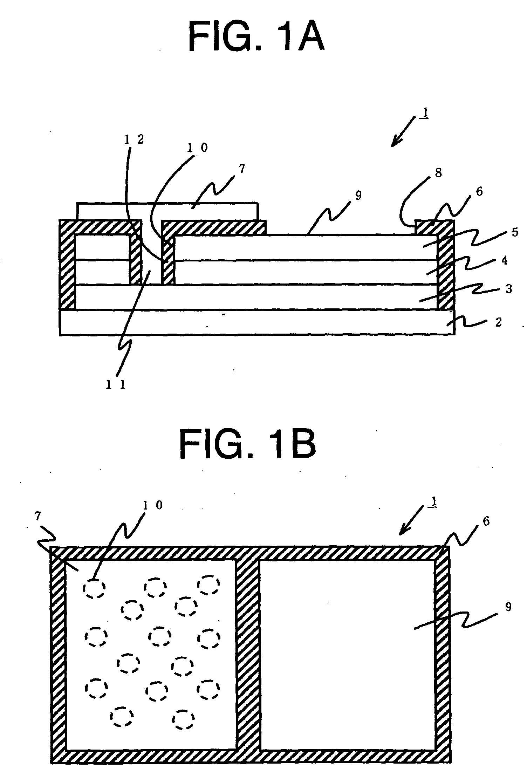

A first preferred embodiment of an organic electroluminescent element or an organic EL element 1 according to the present invention will now be described with reference to FIGS. 1A through 2D. It is noted that a slanted line for indicating cross-section is partially omitted, and the same components are indicated with the same slanted lines for easier recognition irrespective of a cross-sectional view and a front end view in FIGS. 1A through 2D.

FIG. 1A is a schematic cross-sectional view of the organic EL element 1 according to the first preferred embodiment of the present invention. FIG. 1B is a schematic front end view of the organic EL element 1 according to the first preferred embodiment of the present invention. The organic EL element 1 has an anode or a first electrode 3, an organic layer 4, and a cathode or a second electrode 5 on its transparent substrate 2, in this order from a substrate. This layered structure is covered with a sealing film or a sealing member 6. An anode terminal or a first terminal 7 is provided on a portion of the sealing film 6. The sealing film 6 has an opening portion 8. The cathode 5 is exposed through the opening portion 8, in which a cathode terminal or a second terminal 9 is formed.

Additionally, a plurality of through holes 10 is formed in a portion of the sealing film 6. Each through hole 10 extends through the sealing film 6, the cathode 5 and the organic layer 4. The anode terminal 7 is electrically connected to the anode 3 through these through holes 10.

Each component of the organic EL element 1 will now be described.

The substrate 2 is made of glass in the first preferred embodiment but may be made of any transparent materials having a sufficient strength when the anode 3 and the organic layer 4 are deposited thereon. Other than glass, such a material may include a transparent resin.

The anode 3 supplies positive holes to the organic layer 4, and light emitted from the organic layer 4 is output outside through the anode 3 and the substrate 2 in the first preferred embodiment. Thus, the anode 3 needs to be transparent. In the first preferred embodiment, a material for the anode 3 is ITO (indium tin oxide), but the material may be IZO (indium zinc oxide) and the like.

The organic layer 4 needs to have at least a light-emitting layer. The light-emitting layer emits light by recombination of positive holes supplied from the anode 3 and electrons supplied from the cathode 5. The light-emitting layer may be made of a single organic compound or may be made of plural organic compounds.

When the tight-emitting layer is made of plural organic compounds, each layer made of an organic compound may be plurally layered, or may be made of a layer which mixes plural organic compounds.

The organic layer 4 may partially or wholly include a positive hole injection layer or a positive hole transport layer, which is for efficiently transporting positive holes supplied from the anode 3 to the light-emitting layer, and an electron injection layer or an electron transport layer, which is for efficiently transporting electrons supplied from the cathode 5 to the light-emitting layer, in addition to the light-emitting layer. Also, a single layer may have plural functions.

Specifically, the organic layer 4 may be constituted of the following layer structures.
- (Anode) / Positive Hole Injection Layer / Positive Hole Transport Layer / Light-emitting Layer / Electron Transport Layer / Electron Injection Layer / (Cathode)
- (Anode) / Positive Hole Injection Layer / Positive Hole Transport Layer / Light-emitting Layer / Electron Injection Transport Layer / (Cathode)
- (Anode) / Positive Hole Injection Transport Layer / Light-emitting Layer / Electron Transport Layer / Electron Injection Layer / (Cathode)
- (Anode) / Positive Hole Injection Transport Layer / Light-emitting Layer / Electron Injection Transport Layer / (Cathode)
- (Anode) / Positive Hole Transport Layer / Light-emitting Layer / Electron Transport Layer / Electron Injection Layer / (Cathode)
- (Anode) Positive Hole Transport Layer / Light-emitting Layer / Electron Transport Layer / (Cathode)
- (Anode) / Positive Hole Transport Layer / Electron Transport Light-emitting Layer / (Cathode)
- (Anode) / Light-emitting Layer / (Cathode)

The organic layer 4 according to the first preferred embodiment is comprised of a positive hole transport layer, a light-emitting layer, an electron transport layer and an electron injection layer. The light-emitting layer has a three-layer structure, in which a green light-emitting layer, a blue light-emitting layer and a red light-emitting layer are layered on the side of the anode 3 that is opposite to the transparent substrate 2.

The cathode 5 supplies electrons to the organic layer 4, and is made of a material having an electrical conductivity and an airtightness, and preferably made of a material having a low resistivity. Such a material includes metals, alloys and metallic mixtures. In the first preferred embodiment, the cathode 5 is made of aluminum.

A portion of the cathode 5 corresponding to the opening portion 8 of the sealing film 6 is exposed, and in this portion the cathode terminal 9 is formed.

The sealing film 6 functions to prevent the organic layer 4 from being degraded by exposure to moisture (steam) and oxygen in the atmosphere, and is made of a material that is highly airtight. Such a material includes organic polymeric materials, inorganic materials and the like. The organic polymeric materials include epoxy resins, silicone resins, polystyrene resins, and the like. The inorganic materials include glasses, metal oxides, metal nitrides, and the like. In the first preferred embodiment, a silicon nitride film, which is an inorganic material, is used as the seating film 6.

The sealing film 6 covers a portion of the cathode 5 other than the opening portion 8 and the end surfaces of the anode 3 and the organic layer 4.

The anode terminal 7 functions to supply positive holes to the anode 3. The anode terminal 7 may be made of the same material as the cathode 5. In the first preferred embodiment, aluminum is employed for the anode terminal 7.

The through holes 10 function to electrically connect the anode 3 with the anode terminal 7. The plurality of through holes 10 is substantially uniformly distributed on the substrate side of the anode terminal 7. Each through hole 10 includes a conducting portion 11 which is for electrically connecting the anode 3 with the anode terminal 7, and an insulating portion 12 which is for insulating the conducting portion 11 from the organic layer 4 and the cathode 5. In the first preferred embodiment, the conducting portion 11 is integrally formed with the anode terminal 7, and the insulating portion 12 is integrally formed with the sealing film 6.

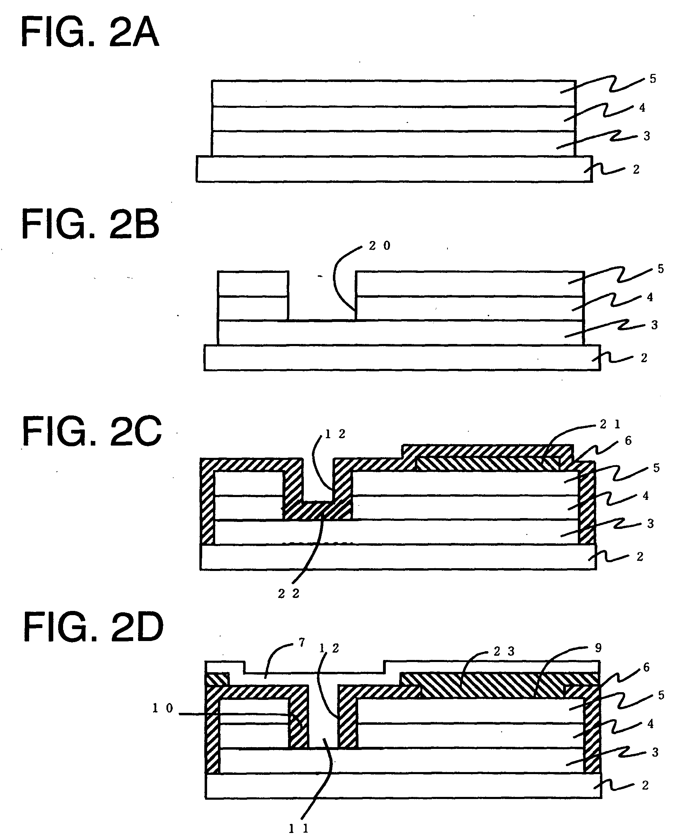

A method of manufacturing the organic EL element 1 will now be described with reference to FIGS. 2A through 2D.

The substrate 2, which provides ITO (the anode 3) of a desired shape on its surface, is washed, and after that is placed in a vacuum evaporator. In the vacuum evaporator, as shown in FIG. 2A, a positive hole transport layer is vapor-deposited on the ITO using a film deposition process. Then, the light-emitting layer is vapor-deposited on the positive hole transport layer in order of a green light-emitting layer, a blue light-emitting layer, and a red light-emitting layer. Subsequently, an electron transport layer and an electron injection layer are vapor-deposited on the light-emitting layer, in this order, thus forming the organic layer 4. Additionally, aluminum is vapor-deposited on the organic layer 4 to form the cathode 5. The thickness of aluminum film ranges from 0.5 µm to 5 µm, and preferably from 1.5 µm to 3 µm.

As shown in FIG. 2B, after forming the cathode 5, a plurality of holes 20 is formed in approximately half of the area of the cathode 5, which extends through the cathode 5 and the organic layer 4 to the anode 3. It is preferable that the holes 20 have a larger diameter, compared to the through holes 10. However, since each of the through holes 10 is a portion that does not emit light, the through hole 10 may be recognized when the diameter of the holes 20 is excessively increased. Therefore, the diameter of the holes 20 preferably range from 50 µm to 0.1mm. The holes 20 may be drilled mechanically or may be drilled by laser drilling and the like.

After the drilling process, a mask 21 is provided on one half of the cathode 5 corresponding to the portion where the holes 20 are not formed. As shown in FIG. 2C, a sealing member 6 is vapor-deposited to cover the top surface and the end surfaces of the cathode 5, the upper surface of the mask 21, the end surfaces of the organic layer 4 and the anode 3. A chemical vapor deposition ("CVD") sealing process is used to form the sealing film 6. Then, the sealing member 6 is also vapor-deposited on the inner surface of the holes 20 to form the insulating portion 12 of the through holes 10 and sealing member 22. Subsequently, the mask 21 is removed. A portion where the mask 21 is removed exposes the cathode 5, and this portion functions as the cathode terminal 9.

After the sealing process, the sealing member 22, which was vapor-deposited on the anode 3 in the hole 20, is removed when necessary. Then, a mask 23 is provided on the exposed portion of the cathode 5. As shown in FiG. 2D, aluminum is vapor-deposited to form the anode terminal 7 in a terminal forming process. At the same time, aluminum is also vapor-deposited to reach the anode 3 in the holes 20, thereby forming the conducting portion 11 of the through hole 10. Finally, the mask 23 and aluminum which is vapor-deposited on the mask 23 are removed.

The operation of the organic EL element 1 will now be described.

The positive electrode of a direct-current power source (not shown) is connected to the anode terminal 7, and the negative electrode thereof is connected to the cathode terminal 9. Positive holes are supplied from the positive electrode of the direct-current power source through the anode terminal 7 and the conducting portion 11 of the through holes 10 to the anode 3. The positive holes supplied to the anode 3 move to the light-emitting layer through the positive hole transport layer in the organic layer 4. The insulating portion 12 is provided around the through holes 10, so that there is no possibility that the positive holes are supplied to the organic layer 4 and the cathode 5 without passing through the anode 3. On the other hand, electrons are supplied from the negative electrode of the direct-current power source through the cathode terminal 9 to the cathode 5. The electrons, which have reached the cathode 5, reach the light-emitting layer through the electron injection layer and the electron transport layer in the organic layer 4.

Positive holes from the anode 3 and electrons from the cathode 5 reach the light-emitting layer and recombine to generate excitons. Lights are emitted when the excitons return to a ground state. In the first preferred embodiment, the light-emitting layer is a three-layer structure, and these three layers respectively emit green light, blue light, and red light. The green, blue, and red light components mixed together are visible as white light.

Light emitted from the light-emitting layer is partially output outside from the substrate 2 through the anode 3. The other light reaches the cathode 5. The cathode 5 made of aluminum has a light reflectivity, so that light which has reached the cathode 5 is reflected and travels through the organic layer 4, the anode 3, and the substrate 2 to the outside.

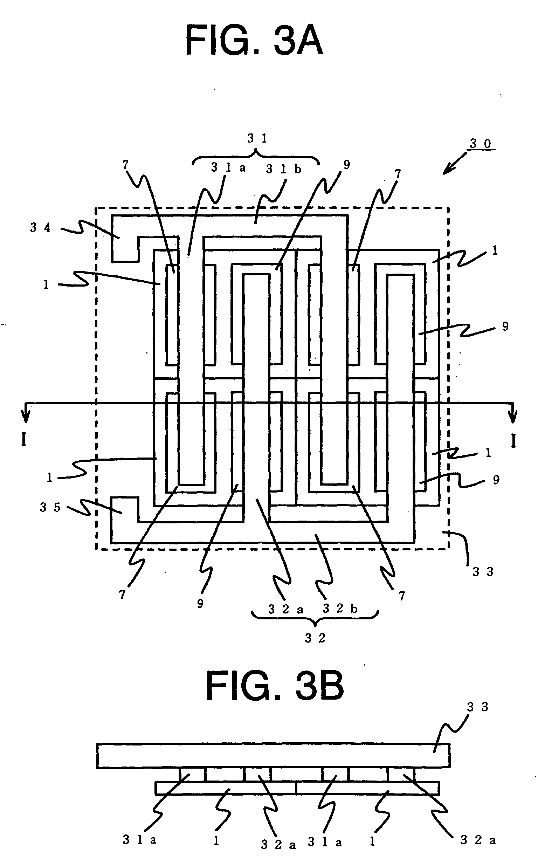

According to the first preferred embodiment, the following advantageous effects are obtained.
(1) The non-light-emitting portion of the organic EL element 1 is reduced.
   Since the anode terminal 7 and the cathode terminal 9, which are for applying voltage to the organic EL element 1, are provided on the opposite side of the light output surface of the substrate 2, the anode 3, the organic layer 4 and the cathode 5 may be formed on the entire surface of the substrate 2. When a voltage is applied between the anode terminal 7 and the cathode terminal 9 of the organic EI element 1, light is output from substantially the entire surface of the substrate 2. Thus, the non-light-emitting portion, which is positioned around the light-emitting portion of the substrate 2, almost disappears.
(2) The cathode terminal 9 also functions as a sealing film.
   The cathode terminal 9 is formed by exposing the cathode 5, and this exposed portion is not covered with the sealing film 6. However, since the cathode 5 is formed to have a thickness of at least 0.5 µm, the cathode 5 is airtight. Accordingly, the cathode terminal 9 functions as a sealing film to prevent ambient moisture and oxygen from entering into the organic EL element. Thus, even if a portion of the cathode 5 is utilized as the cathode terminal 9, the cathode terminal 9 prevents dark spots from forming and prevents the life of the organic EL element 1 from being shortened due to entry of ambient moisture, oxygen, or the like into the organic EL element 1.
(3) The organic EL element 1 emits white light.
   The light-emitting layer of the organic layer 4 is constituted of a layer for emitting green light, a layer for emitting blue light, and a layer for emitting red light. As a voltage is applied to the organic EL element 1, these layers simultaneously emit light and thereby emit white light as a whole. Since the white light emitted from the organic EL element 1 has peaks in a green color spectral range, a blue color spectral range, and a red color spectral range, clear color is produced when displaying an image through an RGB color filter.
(4) The through holes 10 may simultaneously be formed when forming the sealing film 6 and the anode terminal 7.
   The through holes 10 function to physically connect the anode 3 with the anode terminal 7. The conducting portion 11 is formed to electrically connect the anode 3 to the anode terminal 7. On the other hand, the through holes 10 extend through the organic layer 4 and the cathode 5, so that the insulating portion 12 also needs to be formed for insulating the conducting portions 11 of the through holes 10 from the organic layer 4 and the cathode 5. In the first preferred embodiment, when the sealing film 6 is formed for preventing moisture, oxygen and the like from entering into the organic EL element 1, the insulating portions 12 of the through holes 10 are simultaneously formed. Furthermore, when the anode terminal 7 is formed, aluminum is vapor-deposited in the through holes 10 simultaneously forming the conducting portions 11 of the through holes 10. Therefore, another process for forming the through holes 10 need not be prepared.
(5) The interface between the through holes 10 and the organic layer 4 is also sealed.
   The insulating portions 12 of the through holes 10 are simultaneously formed using the same material as the sealing film 6. At the same time, a portion of the sealing film 6, which is for sealing a portion other than the through holes 10, and the insulating portions 12 are continuously and integrally formed. Therefore, the interface between the through holes 10 and the organic layer 4 or the cathode 5 is completely sealed by the sealing film 6 and the insulating portions 12. Accordingly, the organic EL element 1 prevents moisture, oxygen, and the like from entering through the interface between the through holes 10 and the organic layer 4 or the cathode 5 into the organic EL element 1
(6) Utilization rate of light is high.
   An aluminum thin film having a light reflectivity is employed as the cathode 5. Therefore, light traveling from the light-emitting layer to the cathode 5 is reflected toward the substrate 2 on the cathode 5, and the reflected light is partially output outside from the substrate 2. Accordingly, in comparison to the cathode 5 made of a material having no light reflectivity, more light that is emitted from the light-emitting layer is output from the substrate 2.
   A second preferred embodiment of a lighting unit 30 according to the present invention will now be described with reference to FIGS. 3A and 3B. FIG. 3A is a schematic back side view of the lighting unit 30 according to the third preferred embodiment. FIG. 3B is a cross-sectional view that is taken along the line I-I in FIG. 3A. It is noted that a slanted line for indicating cross-section is partially omitted in FIGS. 3A and 3B.
   As shown in FIG. 3A, the lighting unit 30 is formed by arranging the organic EL elements 1 of the first preferred embodiment in a two-by-two matrix. Each anode terminal 7 of the organic EL elements 1 is connected to a positive electrode 31 of the lighting unit 30, and each cathode terminal 9 is connected to a negative electrode 32 of the lighting unit 30. All organic EL elements 1 are fixed to each other by a frame (not shown). The positive electrode 31 and the negative electrode 32 are fixed to a base 33. Additionally, a positive terminal 34, which is electrically connected to the positive electrode 31, and a negative terminal 35 which is electrically connected to the negative electrode 32, are provided along one side of the base 33. It is noted that the outline of the base 33, which should be indicated by a solid line, is indicated by a dotted line. The outlines of the organic EL elements 1, the anode terminals 7, the cathode terminals 9, the positive electrode 31, and the negative electrode 32, which should be indicated by dotted lines, are indicated by solid lines in FIG. 3A for easier recognition.
   A manner of electrical connection between the anode terminals 7 of the organic EL elements 1 and the positive electrode 31 of the lighting unit 30 and a manner of electrical connection between the cathode terminals 9 of the organic EL elements 1 and the negative electrode 32 of the lighting unit 30 will now be described.
   As shown in FIG. 3A, two of four organic EL elements 1 are arranged so that the respective anode terminals 7 are arranged on one line, and the respective cathode terminals 9 are arranged on one line. There are two pairs of the organic EL elements 1 and these pairs are in contact with each other.
   The positive electrode 31 of the lighting unit 30 includes two branches 31a connected to the anode terminals 7 of the organic EL elements 1 and a trunk 31b, which is connected to the positive terminal 34, for connecting these two branches 31a. One branch 31a is arranged to connect two collinear anode terminals 7.
   Likewise, the negative electrode 32 of the lighting unit 30 includes two branches 32a connected to the cathode terminals 9 of the organic EL elements 1 and a trunk 32b, which is connected to the negative terminal 35, for connecting these two branches 32a. One branch 32a is arranged to connect two collinear cathode terminals 9. Accordingly, all organic EL elements 1 are electrically arranged in a parallel relation to each other.
   The operation of the lighting unit 30 will now be described.
   As a voltage is applied between the positive terminal 34 and the negative terminal 35 of the lighting unit 30, the voltage is applied between the anode terminals 7 and the cathode terminals 9 of each organic EL element 1 through the positive electrode 31 and the negative electrode 32. Since, the voltage is simultaneously applied between the anode terminals 7 and the cathode terminals 9 of all organic EL elements 1, all organic EL elements 1 simultaneously emit light.
   According to the second preferred embodiment, the following advantageous effects are obtained.
(7) A lighting unit formed by plural lines of the organic EL elements 1 is obtained.
   Since all organic EL elements 1 are electrically connected in parallel with each other in the lighting unit 30, as voltage is applied between the positive terminal 34 and the negative terminal 35, all organic EL elements 1 simultaneously emit light. Since these organic EL elements 1 are arranged to contact each other, and each non-light-emitting portion of the organic EL element 1 is effectively reduced, almost all portions of the organic EL elements 1 in the lighting unit 30 output light due to the simultaneous light emission of the organic EL elements 1 thereby becoming a large lighting unit as a whole. As the plural organic EL elements 1 are arranged to simultaneously emit light and form a lighting unit that is larger than each organic EL element 1, yield rate of the lighting unit 30 is raised in comparison to a large lighting unit formed by a single organic EL element 1 having the same size.
(8) The organic EL elements 1 forming the lighting unit 30 are easily replaced.
   The organic EL elements 1 forming the lighting unit 30 are connected to the electrodes (the positive electrode 31, the negative electrode 32) of the lighting unit on the opposite surface of the surface through which light is output. Therefore, when some of the organic EL elements 1 forming the lighting unit 30 fail or are degraded, only the failed or degraded organic EL elements 1 may easily be removed and new organic EL elements 1 may easily be installed into the lighting unit 30.
(9) Even if some of the organic EL elements 1 forming the lighting unit 30 are electrically disconnected, the remainder of the organic EL elements 1 continue to emit light.
   Since all organic EL elements 1 forming the lighting unit 30 are electrically connected in parallel with each other, even if some of them are electrically disconnected, there is no possibility that all organic EL elements 1 will stop emitting light, which is the case when all organic EL elements 1 are electrically connected in series. Accordingly, even if one organic EL element 1 loses contact with the electrodes of the lighting unit, the other organic EL elements 1 continue to emit light.

The present invention is not limited to the embodiments described above but may be modified into the following alternative embodiments.

In the first and second preferred embodiments, the light-emitting layer in the organic layer 4 is constituted of three layers including a green light-emitting layer, a blue light-emitting layer, and a red light-emitting layer. The number of light-emitting layers is not limited to three. Two layers or a single layer is applicable. In order to obtain white light with a two-layer light-emitting layer, a specified color and its complementary color, such as blue and yellow, are emitted at the respective light-emitting layers. Also, a material for emitting a specified color may plurally be doped in a single layer. The plural luminescent materials are doped in the single layer thereby to obtain white light even if the number of light-emitting layers is one or two.

The organic EL element 1 according to the first and second preferred embodiments emits white light, but the emitted light may be light other than white light. The light-emitting layer of the organic EL element 1 is appropriately determined based upon a particular application and materials employed.

In the organic EL element 1 according to the first preferred embodiment, the through holes 10 are simultaneously formed when forming the sealing film 6 and the anode terminal 7, but the through holes 10 may be formed by another member. As for a method for forming the through holes 10 by another material, for example, after a desired number of cylindrical micro conductors, which are covered at their outer surfaces with an insulating material, are positioned at predetermined portions of the anode 3, necessary components for the organic EL element 1 may be formed through a film deposition process, a sealing process, and a terminal formation process. At the same time, these micro conductors are electrically connected the anode 3 with the anode terminal 7.

In the first preferred embodiment, the thickness of the cathode 5 is 0.5 µ m or more, but the thickness of the cathode 5 need not be 0.5 µm or more. A portion of the cathode terminal 9 is 0.5 µm or more, but the other portion may be thinner. Since a portion of the cathode 5, other than the cathode terminal 9, is covered with the sealing film 6, the portion of the cathode 5 need not be airtight and may have a thickness of 0.5 µm or below. The portion of the cathode terminal 9 need not be formed simultaneously as a portion of the cathode 5. After the cathode 5 is formed, a separately formed cathode terminal 9 may be provided on a portion where the cathode 5 is not covered-with the sealing film 6, or may be formed by vapor-deposition.

The lighting unit 30 according to the second preferred embodiment includes four organic EL elements 1 which are arranged in a two-by-two matrix, but the structure is not limited thereto. The number of the organic EL elements 1 and arrangement thereof may appropriately be changed when necessary.

In the lighting unit 30 according to the second preferred embodiment, all organic EL elements 1 are electrically connected in parallel with each other, but the organic EL elements 1 need not be all connected in parallel with each other. All organic EL elements 1 may be connected in series, or pairs of parallel organic EL elements 1 may be connected in series, or pairs of series organic EL elements 1 may be connected in parallel with each other. When all organic EL elements 1 are connected in series, electric current flowing in each organic EL element 1 is equal, so that luminescent brightness is substantially the same.

All or portions of the above preferred embodiments may be combined together and conform to the scope of the present invention.

Therefore, the present examples and embodiments are to be considered as illustrative and not restrictive, and the invention is not to be limited to the details given herein but may be modified within the scope of the appended claims.
An organic electroluminescent element has a substrate, a first electrode, an organic layer, a second electrode, a sealing member, a first terminal, and a through hole. The first electrode is layered on the substrate. The organic layer that includes a light-emitting layer is layered on the first electrode. The second electrode is layered on the organic layer. The sealing member partially covers the second electrode. A portion of the second electrode, which is not covered with the sealing member, functions as a second terminal. The first terminal is provided on the sealing member on a side opposite to the second electrode. The through hole . extends through the sealing member, the second electrode, and the organic layer and is used for connecting the first electrode and the first terminal. The first electrode and the second electrode are electrically connected to a power source.

## Claims

1. An organic electroluminescent element formed by layering on a substrate a first electrode, an organic layer that includes a light-emitting layer, a second electrode, in this order, **characterized in that** a sealing member partially covers the second electrode, **in that** a portion of the second electrode, which is not covered with a sealing member, is a second terminal, **in that** a first terminal provided on a portion of the sealing member covers the second electrode, **in that** a through hole extends through the sealing member, the second electrode, and the organic layer, which connects the first electrode and the first terminal, and **in that** the first electrode and the second electrode are capable of being electrically connected to a power source.

2. The organic electroluminescent element according to claim 1, wherein the substrate and the first electrode are transparent.

3. The organic electroluminescent element according to any one of claims 1 and 2, wherein a portion of the second electrode that is not covered with the sealing member ranges from 0.5 µm to 5 µm in thickness.

4. The organic electroluminescent element according to any one of claims 1 through 3, wherein the second electrode is made of aluminum.

5. The organic electroluminescent element according to any one of claims 1 through 4, wherein the light-emitting layer emits white light.

6. A lighting unit comprising a plurality of the organic electroluminescent elements according to any one of claims 1 through 5.

7. The lighting unit according to claim 6, wherein a plurality of the organic electroluminescent elements is electrically connected in parallel with each other.

8. A method of manufacturing an organic electroluminescent element, **characterized by**:
' depositing on a substrate a first electrode, an organic layer including a light-emitting layer, and a second electrode in this order;
drilling a through hole that extends through the second electrode and the organic layer;
sealing a portion of the second electrode that is not covered by a masking layer, end surfaces of the first electrode and the organic layer, and an inner surface of the through hole; and
forming a first terminal on a portion of the sealed portion of the second electrode, which is electrically connected to the first electrode through the through hole.
